# EUROPEAN PATENT SPECIFICATION

(11) **EP 0 438 165 B1**
(45) Date of publication and mention of the grant of the patent: **09.07.1997**
(21) Application number: 91100575.9
(22) Date of filing: 18.01.1991
(51) Int. Cl.: H01R 9/09, H01L 23/053, H01L 23/48, H01R 13/17

(54) **Semiconductor device parts**
Teile einer Halbleitervorrichtung
Parties de dispositif semi-conducteur

(30) Priority: 18.01.1990 JP 9162/90
(43) Date of publication of application: 24.07.1991
(73) Proprietor: KABUSHIKI KAISHA TOSHIBA, Kawasaki-shi, Kanagawa-ken 210 (JP)
(72) Inventor: Deie, Toshikazu, c/o Intellectual Prop. Div., Minato-ku, Tokyo 105 (JP)
(74) Representative: Lehn, Werner, Dipl.-Ing.

(56) References cited:
- EP-A- 342 594
- EP-A- 0 140 473
- EP-A- 0 317 310
- US-A- 4 379 611
- PATENT ABSTRACTS OF JAPAN vol. 9, no. 325 (E-368)(2048) 20 December 1985, & JP- A-60 157243 (MITSUBISHI DENKI) 17 August 1985,
- PATENT ABSTRACTS OF JAPAN vol. 11, no. 396 (E-568)(2843) 24 December 1987, &
- JP-A-62 158349 (KYOCERA) 14 July 1987,
- Encyclopedia of semiconductor technology, 1984, J. Wiley, New York (US), Ed. M. Grayson, p. 124,125

## Description

This invention relates to a semiconductor device parts for use in a plastic packaged high-power semiconductor device and the like, and, more particularly, to a semiconductor device parts comprising external electrode terminals and a terminal supporting body which is a portion of a package of the semiconductor device.

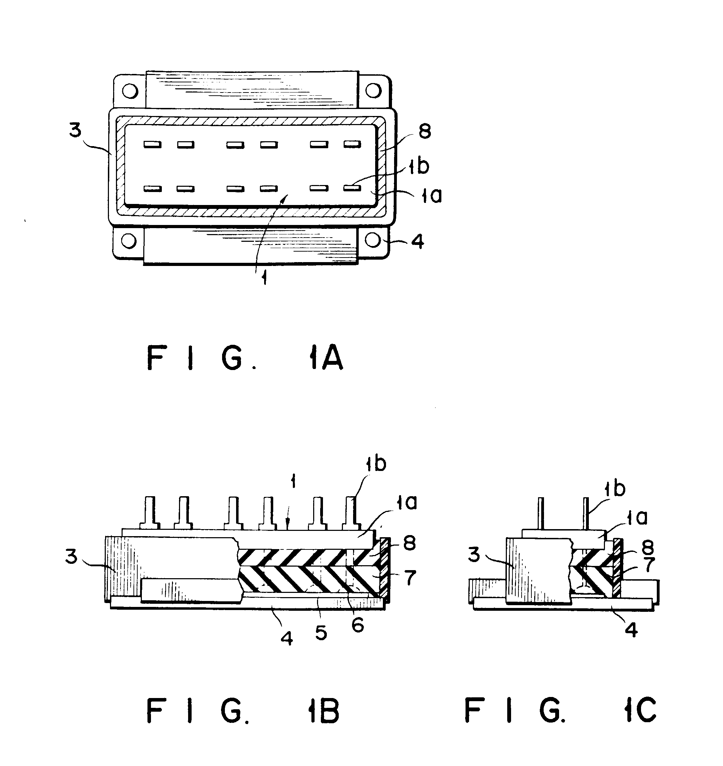

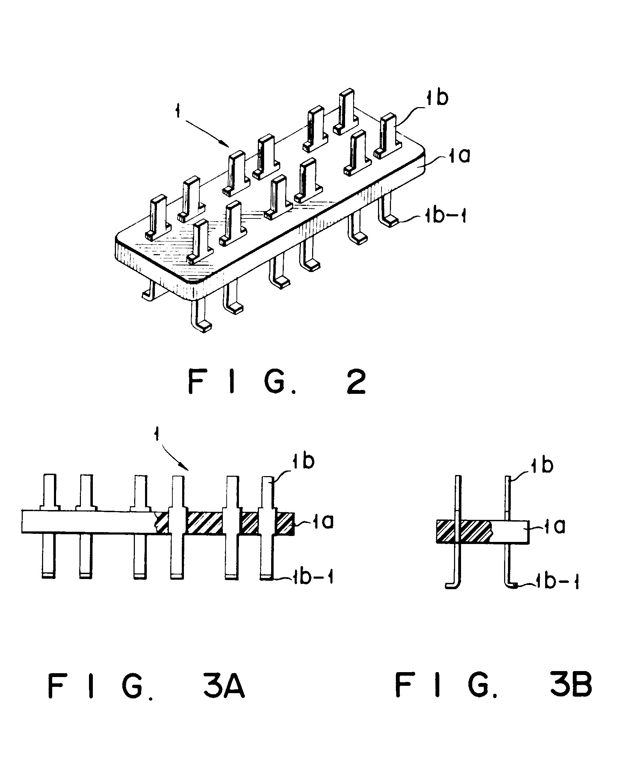

Fig. 1A is a plan view showing an outer appearance of a plastic packaged high-power semiconductor device (G-TR Module) in general, and Figs. 1B and 1C are partially cross-sectioned front and side views, respectively, of the semiconductor device shown in Fig. 1A. In the device shown in Figs. 1A to 1C, a semiconductor chip (not shown) is mounted on a circuit board 5 and electrically connected thereto by bonding wires. An electrode bed (not shown) for deriving electrodes to the external device is formed on the circuit board 5. A plastic terminal supporting body 1a and an external electrode terminal parts 1b are formed integral with each other, constituting a terminal holder 1. The semiconductor device is formed as follows.

First, external electrode terminal parts 1b are placed in a plastic molding die, and plastic is injected into the die to form a terminal holder 1. Inner lead ends of the external electrode terminal parts 1b are adhered by solder 6 to the electrode bed on the circuit board 5. Next, a case 3, a heat radiating board 4, and the like are attached to the circuit board 5. To protect electronic circuits on the circuit board 5 from moisture, vibration, and the like, potting material 7 is injected into the case 3. Further, casting material 8 is injected on the potting material 7. In this way, a semiconductor device is completed as a product.

Fig. 2 is a perspective view showing the outer appearance of conventional semiconductor device parts (a terminal holder 1). Figs. 3A and 3B are partially cross-sectioned front and side views, respectively, of the semiconductor device parts shown in Fig. 2. The external electrode terminal parts 1b for connecting an internal electrode on the circuit board 5 to an external device and the plastic terminal supporting body 1a are formed integral with each other by means of plastic molding by use of a molding die. During the plastic molding, it is necessary to prevent plastic from being forced out through gaps between the molding die and the terminal parts 1b. For this purpose, the terminal parts 1b are fastened tightly by the molding die.

When the number of the external electrode terminal parts 1b are increased or when configurations of the terminal parts 1b are complicated, a complicated molding die must be used. As a result, it may be impossible to form the terminal parts 1b integral with the terminal supporting body 1a. In addition, due to the contacts between the terminal parts 1b and the molding die which occur when the terminal parts 1b are fastened by the molding die or due to the plastic injection pressure which is applied to the external electrode terminal parts 1b when the terminal parts 1b are molded, the external electrode terminal parts 1b tend to be deformed. When deformed defective terminal parts 1b are adhered to the circuit board 5 by a solder 6, the inner lead end 1b-1 of such defective terminal parts 1b cannot be perfectly adhered to the electrode bed. Thus, the defective terminal parts 1b cannot be practically used. Since such defective terminal parts 1b lower the molding yield, the cost of manufacturing the terminal holder is inevitably increased.

EP-0 342 594 A2 discloses an optical semiconductor device having the features of the preamble of claim 1.

It is an object of the present invention to provide semiconductor device parts of high quality which can be manufactured at a low cost, with substantially no defective external electrode terminal parts produced, even in a case that the semiconductor device parts have a great number of external electrode terminal parts or external electrode terminal parts of a complicated configuration.

This object is achieved by a device having the features described in the appended claim 1. The subclaims describe advantageous embodiments.

According to the present invention, external electrode terminal parts and a plastic terminal supporting body are individually prepared, and the terminal parts are inserted into through holes in the terminal supporting body, thereby completing a terminal holder. A stopper portion is provided at a predetermined position on each of the terminal parts in the longitudinal direction such that the stopper portion is wider than the width of the through hole in the terminal supporting body. Hence, the distance between the terminal supporting body and the end of the external electrode terminal parts is defined when the terminal parts are inserted into through holes in the terminal supporting body. In addition, since the terminal parts includes a spring portion which abuts against the inner wall of the through hole in the terminal supporting body when inserted therein, the terminal parts cannot be slipped out of the terminal supporting body.

The terminal holder of the present invention is formed by only inserting the external electrode terminal parts into the through holes in a plastic terminal supporting body. Therefore, unlike in a conventional terminal holder, the terminal parts do not deform, and a terminal holder can be manufactured easily even if the number of the terminal parts is large or the configuration thereof is complicated.

This invention can be more fully understood from the following detailed description when taken in conjunction with the accompanying drawings, in which:
Fig. 1A is a plan view showing an outer appearance of a plastic packaged high-power semiconductor device in general;
Fig. 1B is a partially cross-sectioned front view of the semiconductor device shown in Fig. 1A;
Fig. 1C is a partially cross-sectioned side view of the semiconductor device shown in Fig. 1A;
Fig. 2 is a perspective view showing an outer appearance of conventional semiconductor device parts;
Fig. 3A is a partially cross-sectioned front view of the parts shown in Fig. 2;
Fig. 3B is a partially cross-sectioned side view of the parts shown in Fig. 2;
Fig. 4 is a perspective view showing an embodiment of semiconductor device parts before assembled, according to the present invention;
Fig. 5A is a partially cross-sectioned front view of the parts shown in Fig. 4;
Fig. 5B is a partially cross-sectioned side view of the parts shown in Fig. 4;
Fig. 6A is a partially cross-sectioned front view of the embodiment of the semiconductor device parts after assembled, according to the present invention;
Fig. 6B is a partially cross-sectioned side view of the parts shown in Fig. 6A; and
Fig. 7 is a diagram showing rates of occurrence of deformed defective external electrode terminal parts.

An embodiment of semiconductor device parts according to the present invention will now be described with reference to the accompanying drawings.

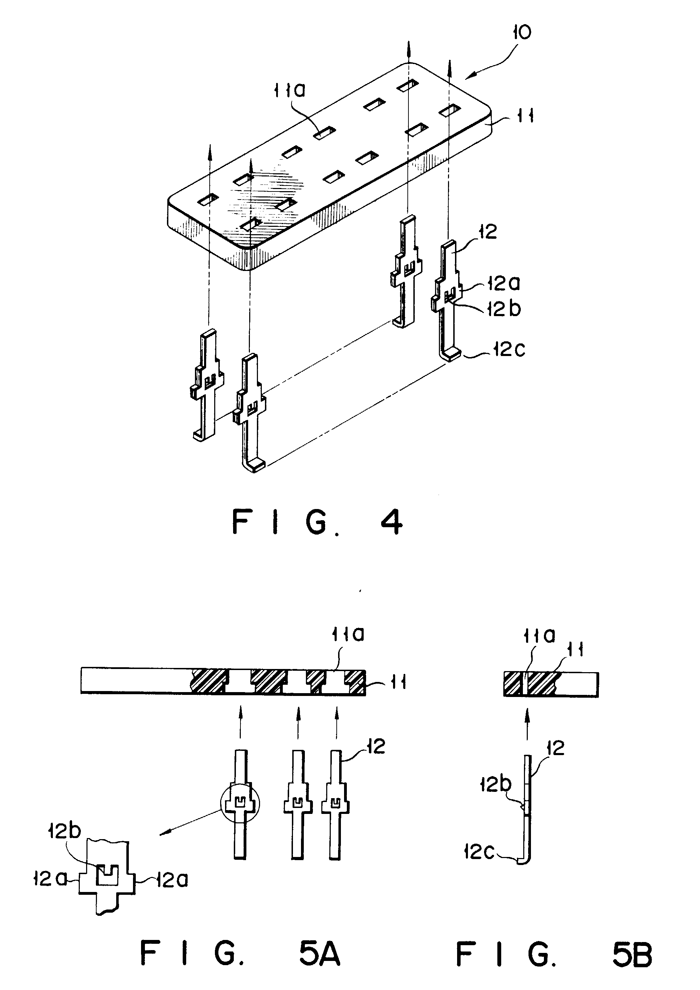

Fig. 4 is a perspective view showing an embodiment of semiconductor device parts, i.e., a terminal holder 10 before assembled. Figs. 5A and 5B are partially cross-sectioned front and side views, respectively, of the terminal holder 10. In Fig. 4, a terminal supporting body 11 and external electrode terminal parts 12 are separated from each other. According to this invention, first, external electrode terminal parts 12 and a terminal supporting body 11 are individually formed, and thereafter assembled into a terminal holder 10. The plastic terminal supporting body 11 serves as a portion of a package of a plastic packaged semiconductor device, as is generally shown in Fig. 1. A number of rectangular stepped through holes 11a into which the terminal parts 12 are inserted are formed in the terminal supporting body 11. Each of the holes has a stepped portion. The external electrode terminal parts 12 is inserted into the stepped hole 11a to connect an internal electrode of the semiconductor device to an external device. A stopper portion 12a which is wider than the longitudinal length of the stepped hole 11a and a spring portion 12b which abuts against the inner wall of the stepped hole 11a are provided in the middle of the external electrode terminal parts 12. Thus, the parts 12 is prevented from being slipped out of the stepped hole 11a. The configuration of the stopper portion 12a is determined so as to fit in with that of the stepped hole 11a. The position of the stopper portion 12a is determined so that inner and outer lead portions of the terminal parts 12 protrude by predetermined lengths from the surface of the supporting body 11 when the terminal parts 12 is inserted into the stepped hole 11a until the stopper portion 12a, i.e., a wider portion of the terminal parts 12 abuts against the shoulder portion of the stepped hole 11a of the terminal supporting body 11. Thus, the distance between the terminal support 11 and the end of the terminal parts 12 is defined. The spring portion 12b is punched and bent as a tongue piece in one direction by a press step. An inner lead end 12c of the terminal parts 12 is bent to ensure the contact with the electrode bed.

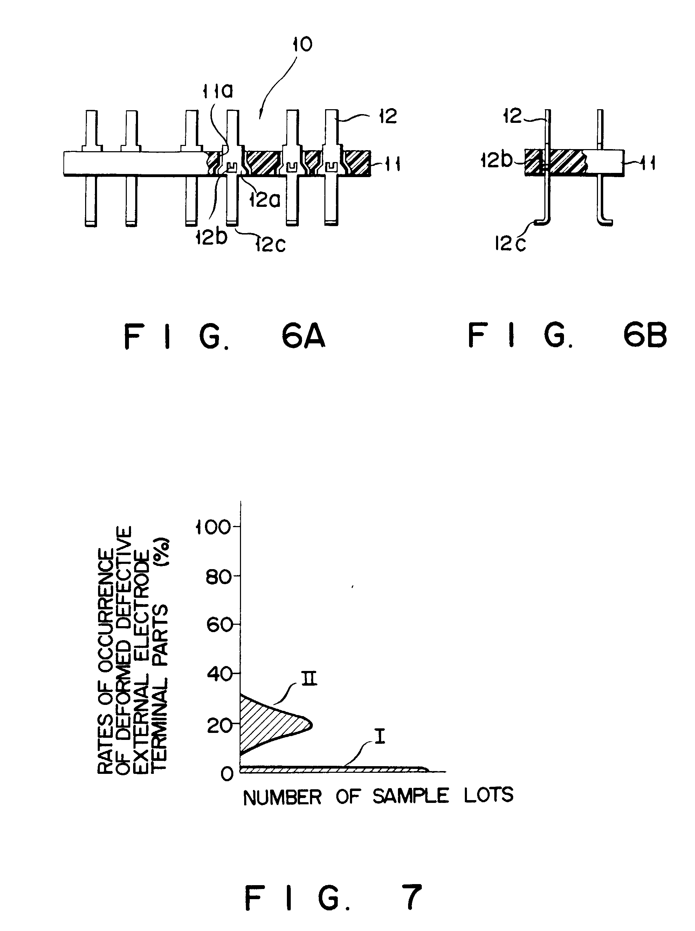

Figs. 6A and 6B are partially cross-sectioned front and side views, respectively, showing the embodiment of the semiconductor device parts after assembled, according to the present invention. The terminal holder 10 is completed by inserting the external electrode terminal parts 12 in the stepped hole 11a of the terminal supporting body 11 outwardly from the package, i.e., in the direction as indicated by the arrows in Figs. 4 and 5. In this assembled state, there is a clearance between the terminal parts 12 and the inner wall of the stepped hole 11a of the terminal supporting body 11. However, since the spring portion 12b of the terminal parts 12 abuts against the inner wall of the stepped hole 11a when the terminal parts 12 is inserted in the stepped hole 11a, the terminal parts 12 is fixed to the terminal supporting body 11 and are not slipped out.

The steps of mounting a semiconductor chip on the circuit board 5, connecting the semiconductor chip with the circuit board 5 by the bonding wires, and adhering the inner lead end 12c with the inner electrode bed on the circuit substrate 5 by a brazing material (solder etc.) are performed in the same manner as shown in Fig. 1.

Fig. 7 is a diagram showing rates of occurrence of deformed defective external electrode terminal parts during the molding step. In the diagram, the abscissa denotes the number of sample lots, and the ordinate denotes the rate of occurrence (%) of deformed defective external electrode terminal parts in each of the lots. A curve I represents rates of occurrence of defective terminal holders 10 according to the present invention in which external electrode terminal parts 12 and a plastic supporting body are individually formed and thereafter assembled. A curve II represents rates of occurrence of defective terminal holders according to the conventional art in which external electrode terminal parts are formed integral with a supporting body by the plastic molding. As is clearly shown in Fig. 7, the rates of occurrence of defective terminal holders according to the present invention are suppressed to substantially zero.

As has been described above, the terminal holder 10 of the present invention is formed by inserting the terminal parts 12 into the supporting body 11, which have been formed independently each other. Hence, a large number of external electrode terminal parts or those of a complicated configuration can be manufactured easily unlike in the conventional art. Moreover, since substantially no defective parts can be produced in the step of forming the terminal holder of the present invention, the manufacturing cost can be reduced as compared to the conventional parts.

## Claims

1. A plastic packaged semiconductor device comprising:
- a terminal holder (10) and
- a semiconductor device, the terminal holder (10) having:
- a terminal supporting means (11) which is made of plastic material having a plurality of through holes (11a); and
- a plurality of external electrode terminal means (12), each being inserted in each of said plurality of said through holes (11a) and connecting internal electrodes of the packaged semiconductor device to an external device;
**characterized in that**
- each of said plurality of external electrode terminal means (12) has:
- a stopper portion (12a) which engages with one of said through holes (11a) to position each external electrode terminal means (12) in a proper position for said internal electrodes when said semiconductor device is packaged; and
- a spring portion (12b) which abuts against an inner wall of said through hole (11a) to hold said each external electrode terminal means (12) in said proper position without slip when said each external electrode terminal means (12) is inserted into said through hole.

2. The device according to claim 1,
**characterized in that**
said through holes (11a) are stepped holes, and said stopper portion (12a) is a stepped shoulder portion which fit in with said stepped hole (11a).

3. The device according to claim 1,
**characterized in that**
said spring portion (12b) of each external electrode terminal means (12) is formed by bending a portion of said external electrode terminal means (12) in one direction.

4. The device according to claim 1,
**characterized in that**
said stopper portion (12a) and said spring portion (12b) are formed at substantially the same predetermined positions of every external electrode terminal means (12) in its longitudinal direction.

## Patentansprüche

1. Plastikverpackte Halbleitervorrichtung, umfassend:
- einen Anschlußhalter (10) und
- eine Halbleitervorrichtung, wobei der Anschlußhalter (10)
- eine Anschlußtragevorrichtung (11) hat, welche aus einem Plastikmaterial hergestellt ist, das eine Vielzahl von Durchgangslöchern (11a) hat;
- eine Vielzahl von externen Elektrodenanschlußvorrichtungen (12) hat, wovon jede in jedes der Vielzahl von Durchgangslöchern (11a) eingeführt wird und interne Elektroden der verpackten Halbleitervorrichtung mit einer externen Vorrichtung verbindet;
dadurch gekennzeichnet, daß
- jede der Vielzahl von externen Elektrodenanschlußvorrichtungen (12) hat:
- einen Anschlagabschnitt (12a), welcher mit einem der Durchgangslöcher (11a) eingreift, um jede externe Elektrodenanschlußvorrichtungen (12) in einer richtigen Position für die internen Elektroden zu plazieren wenn die Halbleitervorrichtung verpackt ist;
- einen Federabschnitt (12b), welcher gegen eine Innenwand des Durchgangslochs (11a) stößt, um jede der externen Elektrodenanschlußvorrichtungen (12) in der richtigen Position ohne Verrutschen zu halten wenn die externe Elektrodenanschlußvorrichtung (12) in dem Durchgangsloch eingeführt ist.

2. Vorrichtung nach Anspruch 1, dadurch gekennzeichnet, daß die Durchgangslöcher (11a) gestufte Löcher sind, und der Anschlagabschnitt (12a) ein gestufter Schulterabschnitt ist, welcher in das gestufte Loch (11a) paßt.

3. Vorrichtung nach Anspruch 1, dadurch gekennzeichnet, daß der Federabschnitt (12b) jeder externen Elektrodenanschlußvorrichtung (12) durch Biegen eines Abschnitts der externen Elektrodenanschlußvorrichtungen (12) in eine Richtung gebildet wird.

4. Vorrichtung nach Anspruch 1, dadurch gekennzeichnet, daß der Anschlagabschnitt (12a) und der Federabschnitt (12b) im wesentlichen an den gleichen vorbestimmten Positionen jeder externen Elektrodenanschlußvorrichtung (12) in seiner Longitudinalrichtung gebildet sind.

## Revendications

1. Dispositif à semi-conducteur mis sous boîtier en plastique comprenant :
un bornier (10) et
un dispositif à semi-conducteur, le bornier (10) comportant :
un moyen formant support de bornes (11) qui est fait d'une matière plastique comportant une pluralité de trous traversants (11a) ; et
une pluralité de moyens formant borne d'électrode externe (12), chacun étant introduit dans chacun de ladite pluralité desdits trous traversants (11a), et des électrodes internes de connexion du dispositif à semi-conducteur mis sous boîtier à un dispositif externe ;
caractérisé en ce que :
chacun de ladite pluralité de moyens formant borne d'électrode externe (12) comporte :
une partie formant butée (12a) qui coopère avec l'un desdits trous traversants (11a) pour positionner chaque moyen formant borne d'électrode externe (12) dans une position appropriée pour lesdites électrodes internes, lorsque ledit dispositif à semi-conducteur est mis sous boîtier ; et
une partie à ressort (12b) qui bute contre une paroi interne dudit trou traversant (11a) pour maintenir chacun desdits moyens formant borne d'électrode externe (12) dans ladite position appropriée, sans glisser lorsque chacun desdits moyens formant borne d'électrode externe (12) est introduit dans ledit trou traversant.

2. Dispositif selon la revendication 1,
caractérisé en ce que :
lesdits trous traversants (11a) sont des trous en gradins, et en ce que ladite partie formant butée (12a) est une partie formant épaulement en gradins qui s'adapte audit trou en gradins (11a).

3. Dispositif selon la revendication 1,
caractérisé en ce que :
ladite partie à ressort (12b) de chaque moyen formant borne d'électrode externe (12) est formée en recourbant une partie dudit moyen formant borne d'électrode externe (12) dans un certain sens.

4. Dispositif selon la revendication 1,
caractérisé en ce que :
ladite partie formant butée (12a) et ladite partie à ressort (12b) sont formées sensiblement dans les mêmes positions prédéterminées de tous les moyens formant borne d'électrode externe (12) dans leur direction longitudinale.
